# EUROPÄISCHE PATENTSCHRIFT

(11) **EP 2 020 339 B1**
(45) Veröffentlichungstag und Bekanntmachung des Hinweises auf die Patenterteilung: **28.03.2012**
(21) Anmeldenummer: 07014972.9
(22) Anmeldetag: 31.07.2007
(51) Int. Cl.: B60R 21/0136, G01L 1/18

(54) **Auslösevorrichtung für eine Sicherheitseinrichtung in einem Kraftfahrzeug**
Activation device for the safety device in a motor vehicle
Dispositif de déclenchement pour un dispositif de sécurité dans un véhicule

(43) Veröffentlichungstag der Anmeldung: 04.02.2009
(73) Patentinhaber: Micronas GmbH, 79108 Freiburg i. Br. (DE)
(72) Erfinder: Franke, Jörg, Dipl.-Ing., 79117 Freiburg (DE)
(74) Vertreter: Koch Müller Patentanwaltsgesellschaft mbH

(56) Entgegenhaltungen:
- EP-A- 0 978 425
- EP-A- 1 604 870
- DE-A1- 4 237 404
- DE-A1-102005 014 013
- US-A1- 2006 241 834

## Beschreibung

Die Erfindung betrifft eine Auslösevorrichtung nach dem Oberbegriff von Anspruch 1.

Aus US 2006/0241834 A1 ist eine Auslösevorrichtung für einen Airbag eines Kraftfahrzeugs bekannt, die einen piezoelektrischen Kraftsensor aufweist, der in einen anwendungsspezifischen Schaltkreis eines Halbleiterchips (ASIC) integriert ist. Der Halbleiterchip ist derart an der Windschutzscheibe des Kraftfahrzeugs befestigt, dass bei einer Deformation der Karosserie des Kraftfahrzeugs auf die Windschutzscheibe einwirkende Kräfte an einem Messsignalausgang des Kraftsensors ein Messsignal hervorrufen. Zur Verarbeitung des Messsignals ist mit dem Messsignalausgang eine Auswerteeinrichtung verbunden, die in den Halbleiterchip integriert ist. Die Auswerteeinrichtung hat zwei Kanäle. Ein erster Kanal ist für die Analyse von bei einer Kollision auftretenden hochfrequenten Messsignalanteilen ausgestaltet. Ein zweiter Kanal ermöglicht die Analyse niederfrequenter Messsignalanteile. Dieser Kanal ist für Diagnosezwecke vorgesehen. Die Auslösevorrichtung weist jedoch nur relativ begrenzte Diagnosemöglichkeiten auf

Aus EP 1 604 870 A2 ist ferner eine Auslösevorrichtung für einen Airbag bekannt, die ein Halbleiterbauelement aufweist, in das mehrere piezoresistive Kraftsensoren integriert sind. Das Halbleiterbauelement ist über elektrische Leitungen mit einem ASIC verbunden, in das eine Auswerteeinrichtung integriert ist. Mit Hilfe der Auswerteeinrichtung werden Veränderungen der Kraffisensor-Messsignale, die auf eine Kollision des Kraftfahrzeugs hindeuten, detektiert. Wenn auf diese Weise eine Kollision erkannt wird, löst die Auswerteeinrichtung den Airbag aus. Zusätzlich zu den piezoresistiven Kraftsensoren weist die Auslösevorrichtung als weitere Kollisionssensoren einen Drucksensor, einen Geschwindigkeitssensor, einen Bremsensensor, einen Lenkradsensor und einen magnetorestriktiven Sensor auf Die Auslösevorrichtung verfügt jedoch nicht über eine Diagnosefunktion.

Aus DE 42 37 404 A1 ist ferner eine Auslösevorrichtung für einen Seitenairbag bekannt, die als Kraftsensor eine piezoelektrische Folie aufweist, die direkt auf einer in einer Kraffahrzeugtüre vorgesehenen Versteifung angeordnet ist. Die Folie ist über ein Kabel mit einer Auswerteeinrichtung verbunden, welche anhand eines von der piezoelektrischen Folie bereitgestellten Messsignals den Verformungsgrad und die Verformungsgeschwindigkeit der Versteifung bewertet und erforderlichen Falls den Seitenairbag auslöst. Die Auslösevorrichtung weist eine Diagnosefunktion auf, bei der vorbestimmte elektrische Signale an Schaltungskomponenten der Auslösevorrichtung angelegt werden und bei der mittels eines Analog/Digitalumsetzers die Reaktion der Schaltungskomponenten auf die Signale in einen Mikroprozessor eingelesen und mit abgespeicherten Referenzwerten verglichen wird.

Es besteht deshalb die Aufgabe, eine Auslöseeinrichtung der eingangs genannten Art zu schaffen, die eine Diagnose der Auslöseeinrichtung und/oder Kompensation des Messsignals gegen Störeinflüsse ermöglicht.

Diese Aufgabe wird mit den Merkmalen des Anspruchs 1 gelöst.

Mit Hilfe des kapazitiven Sensors kann der Abstand des CMOS-Chip zur Karosserie und somit das Vorhanden sein der kraftschlüssigen Verbindung zur Karosserie überprüft werden. Der mindestens eine Kraftsensor und die Auswerteeinrichtung können mit einem Standard-CMOS-Prozess kostengünstig in großer Stückzahl als CMOS-Chip hergestellt werden, wobei auch die elektrischen Verbindungsleitungen zwischen dem Kraftsensor und der Auswerteeinrichtung in den CMOS-Chip integriert werden können. Die Auswerteeinrichtung umfasst bevorzugt zumindest einen Filter für das Messsignal des Piezoelements. Das gefilterte Messsignal, das vorzugsweise eine geringeres Datenvolumen aufweist als das ungefilterte Messsignal, kann dann zu einem weiteren Halbleiterchip übertragen werden, um dort in Abhängigkeit von dem gefilterten Messsignal und ggf. dem gefilterten Messsignal mindestens eines weiteren, ein Piezoelement und eine Auswerteeinrichtung aufweisenden CMOS-Chips ein Auslösesignal für die Sicherheitseinrichtung zu erzeugen.

Bei einer vorteilhaften Ausgestaltung der Erfindung weist der CMOS-Chip mehrere Piezoelemente auf, die vorzugsweise zu einer Brückenschaltung, insbesondere einer Wheatstone Brücke miteinander verbunden sind. Dadurch können Veränderungen des Messsignals, die auf Temperaturschwankungen und/oder Toleranzen in den Piezoelementen zurückzuführen sind, weitestgehend vermieden werden. Gegebenfalls ist es sogar möglich, dass zur Kompensation einer eventuell noch verbleibenden Abhängigkeit des Messsignals von der Temperatur in den CMOS-Chip eine einen Temperatursensor aufweisende Kompensationsschaltung integriert ist. Die Brückenschaltung kann auch softwaremäßig nachgebildet sein, wobei die Messsignale mehrerer Piezoelemente getrennt voneinander erfasst und mit Hilfe eines Mikrocomputers miteinander verknüpft werden.

Bei einer bevorzugten Ausführungsform der Erfindung hat die Auswerteeinrichtung einen nicht flüchtigen Datenspeicher, in dem mindestens ein Auslösekennwert gespeichert ist, wobei die Auswerteeinrichtung eine Vergleichseinrichtung zum Vergleichen des mindestens einen Auslösekennwerts mit dem Messsignal aufweist, und wobei die Auswerteeinrichtung derart ausgestaltet ist, dass ein Auslösesignal in Abhängigkeit von dem Ergebnis dieses Vergleichs generierbar ist. Als Datenspeicher ist bevorzugt ein E²-Prom vorgesehen. Der CMOS-Chip kann dann auf einfache Weise an unterschiedliche Kraftfahrzeuge und/oder unterschiedliche Einbausituationen in einem Kraftfahrzeug angepasst werden, indem In den Datenspeicher eine oder mehrere entsprechende Kenngröße einprogrammiert wird (werden), die den CMOS-Chip an die jeweils gewünschte Auslösecharakteristik anpassen. Somit kann für unterschiedliche Anwendungsfälle der gleiche CMOS-Chip verwendet werden.

Vorteilhaft ist, wenn der CMOS-Chip mehrere mit der Auswerteeinrichtung verbundene Piezoelemente aufweist, mit denen Kraft-Messsignale für mindestens zwei quer zueinander angeordnete Hauptmessrichtungen messbar sind, und wenn die Auswerteeinrichtung derart ausgestaltet ist, dass das Auslösesignal in Abhängigkeit vom Betrag, der Änderungsgeschwindigkeit und/oder der Richtung eines aus den Messsignalen gebildeten resultierenden Messsignals generierbar ist. Dadurch Ist es möglich, das Auslösesignal nur beim Auftreten bestimmter Deformationen der Fahrzeug-Karosserie, wie z.B. bei einem Seitenaufprall und/oder einem Frontalaufprall zu aktivieren.

Zweckmäßigerweise hat die Auslösevorrichtung mindestens zwei Piezoelemente, die unter einem Winkel von etwa 45° zueinander angeordnet sind, wobei zumindest eines dieser Piezoelemente mit seiner Hauptmessrichtung vorzugsweise parallel zur Ausrichtung der Kristalle im CMOS-Chip und/oder zu einem Randbereich und/oder einer Kante des CMOS-Chips angeordnet ist. Mit dem mit seiner Messrichtung in der einen Richtung angeordneten Piezoelement wird hauptsächlich die Oberflächenspannung des CMOS-Chips gemessen, während mit dem mit seiner Messrichtung in die andere Richtung angeordneten Piezoelement hauptsächlich die Scherspannung im CMOS-Chip bzw. das auf den CMOS-Chip einwirkende Drehmoment gemessen wird. In Abhängigkeit von den Messsignalen für die Oberflächenspannung und die Scherspannung kann dann auf die Art der Deformation der Karosserie geschlossen werden. Dadurch ist es möglich, die Sicherheitseinrichtung nur bei bestimmten Deformationsmustern auszulösen. Die Piezoelemente sind vorzugsweise derart angeordnet, dass die Scherspannung und die Oberflächenspannung jeweils in drei quer und vorzugsweise orthogonal zueinander verlaufenden Achsen (a, b, c bzw. x, y, z) gemessen werden können.

Bei einer bevorzugten Ausgestaltung der Erfindung ist der CMOS-Chip über mindestens eine vorzugsweise etwa parallel zu seiner Haupterstreckungsebene verlaufende Klebstoffschicht flächig und kraftschlüssig mit einem ersten Oberflächenbereich der Fahrzeug-Karosserie verbunden, wobei die aus dem CMOS-Chip und der mindestens einen Klebstoffschicht bestehende Anordnung mit einer verfestigten Vergussmasse überdeckt ist, die dicht mit einem die Klebstoffschicht seitlich umgrenzenden zweiten Oberflächenbereich der Fahrzeug-Karosserie verbunden ist. Der CMOS-Chip kann dann bei der Fertigung der Fahrzeug-Karosserie direkt auf diese aufgeklebt und danach derart mit der Vergussmasse umspritzt werden, dass der CMOS-Chip durch die Vergussmasse und die Fahrzeug-Karosserie umkapselt wird. Bei einer Deformation der Karosserie werden die auf die Karosserie einwirkenden Deformationskröfte über die Klebstoffschicht direkt auf den CMOS-Chip und somit den mindestens einen Kraftsensor übertragen. Die Vergussmasse besteht bevorzugt aus einem weichen Material, dessen Nachgiebigkeit so gewählt ist, dass bei einer Deformation der Karosserie die Kräfte hauptsächlich über die Klebstoffschicht von der Karosserie auf den CMOS-Chip übertragen werden.

Zweckmäßigerweise ist der CMOS-Chip über mindestens zwei gestapelte Klebstoffschichten mit dem ersten Oberflächenbereich der Fahrzeug-Karosserie verbunden, wobei zwischen diesen Klebstoffschichten eine Metallfolie angeordnet ist. Die Metallfolie ermöglicht dabei eine gut wärmeleitenden Verbindung zwischen dem CMOS-Chip und der Karosserie, so dass in dem CMOS-Chip auftretende Verlustwärme über die Karosserie großflächig an die Umgebung abgeleitet werden kann.

Bei einer vorteilhaften Ausführungsform der Erfindung ist der CMOS-Chip mit einer diesen dicht umschließenden Vergussmasse umspritzt, wobei die Vergussmasse mindestens zwei seitlich voneinander beabstandete Lochungen aufweist, durch die Befestigungselemente hindurchgeführt sind, über welche das durch den CMOS-Chip und die Vergussmasse gebildete elektronische Bauteil kraftschlüssig mit der Karosserie verbunden ist. Dabei sind als Befestigungselemente bevorzugt Schrauben vorgesehen. Die Auslösevorrichtung kann dann im Servicefall leicht von der Karosserie gelöst und durch ein entsprechendes Ersatzteil ersetzt werden. Der CMOS-Chip ist bevorzugt zwischen den Lochungen angeordnet, so dass auf die Karosserie einwirkende Deformationskräfte über die Befestigungselemente und die vorzugsweise harte Vergussmasse gut auf den CMOS-Chip übertragen werden können.

Bei einer anderen vorteilhaften Ausführungsform der Erfindung ist der CMOS-Chip über eine über eine an der Karosserie (4) anhaftende Vergussmasse kraftschlüssig mit der Karosserie des Kraftfahrzeugs verbunden, wobei die Vergussmasse vorzugsweise zwischen dem CMOS-Chip und der Karosserie angeordnet ist und/oder die Karosserie hintergreift. Dabei ist es sogar möglich dass die Vergussmasse mindestens eine in einer Wandung der Karosserie vorgesehene Lochung durchsetzt und einen Randbereich dieser Lochung an der dem CMOS-Chip abgewandten Seite der Karosserie-Wandung hintergreift.

Bei einer anderen Ausgestaltung der Erfindung Ist das Bauteil von einem vorzugsweise plattenförmigen Halteteil überdeckt, wobei das Halteteil beidseits des elektronischen Bauteils an Befestigungsstellen mit der Karosserie verspannt und zwischen den Befestigungsstellen über das elektronische Bauteil gegen die Karosserie abgestützt ist. Das aus der Vergussmasse oder der Umkapselung und dem CMOS-Chip gebildete Bauteil wird dann durch das Halteteil vorzugsweise flächig an die Karosserie angepresst und verformt sich bei einer Deformation der Karosserie zusammen mit dieser.

Vorteilhaft ist, wenn das Bauteil an einem einen Teil der Außenhaut der Karosserie bildenden Karosseriewandung befestigt ist, insbesondere an deren der Fahrzeugaußenseite abgewandten Rückseite. Auf die Außenhaut der Karosserie einwirkende Deformationskröfte können dann bereits zu Beginn der Deformation direkt von dem mindestens einen Piezoelement gemessen werden.

Bei einer bevorzugten Ausgestaltung der Erfindung ist in den CMOS-Chip ein BUS-Interface integriert, das vorzugsweise zum PSI5-Standard kompatibel ist.

Bei einer bevorzugten Ausführungsform der Erfindung weist die Auslösevorrichtung eine Diagnoseeinrichtung auf, die Mittel zum Detektieren eines im Messsignal enthaltenen Signalanteils hat, der durch Vibrationen hervorgerufen wird, die durch einen Antriebsmotor des Kraftfahrzeugs verursacht werden, insbesondere durch einen Verbrennungsmotor. Mit Hilfe der Diagnoseeinrichtung kann dann überprüft werden, ob der Kraftsensor funktionsfähig und kraftschlüssig mit der Karosserie verbunden ist. Sollte sich der Kraftsensor einmal von der Karosserie ablösen, würden die Motorvibrationen nicht mehr oder nur noch zu einem kleinen Teil auf den Kraftsensor übertragen. Dieser Defekt könnte dann mit Hilfe der Diagnoseeinrichtung festgestellt und ggf zur Anzeige gebracht werden. Die Diagnoseeinrichtung kann außerdem Mittel zum überprüfen der elektrischen Betriebsspannung des CMOS-Chips und/oder Funktionsfähigkeit des BUS-Interface aufweisen. Beim Feststellen des Defekts kann die Sicherheitseinrichtung auf ein Notbetriebsprogramm umgeschaltet werden.

Nachfolgend sind Ausführungsbeispiele der Erfindung anhand der Zeichnung näher erläutert. Es zeigt
- Fig. 1: einen Querschnitt durch einen flächig auf eine Karosserie aufgeklebten CMOS-Chip, in den piezoresistive Kraftsensoren und eine Auswerteein- richtung monolithisch integriert sind,
- Fig. 2: ein Blockschaltbild eines CMOS-Chips, in den eine Schaltung zum Auslösen eines Airbags in einem Kraftfahrzeug integriert ist,
- Fig. 3: ein Aufsicht auf ein einen CMOS-Chip enthaltendes elektrisches Bauteil, das an mehreren Stellen mit einer Karosserie verschraubt ist,
- Fig. 4: einen Querschnitt durch die in Fig. 3 gezeigte Anordnung,
- Fig. 5: eine Seitenansicht eines einen CMOS-Chip enthaltenden elektrischen Bauteils, das zwischen einem plattenförmigen Halteteil und einer Karosserie eingespannt ist, und
- Fig. 6: einen Querschnitt durch einen CMOS-Chip, der mit einer die Karosserie formschlüssig hintergreifenden Vergussmasse umkapselt ist.

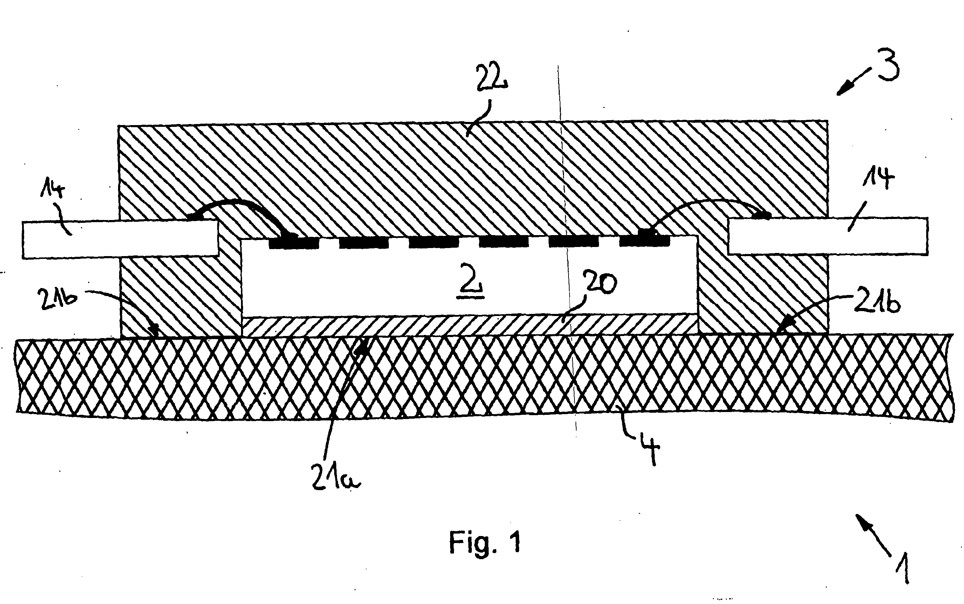

Eine in Fig. 1 im Ganzen mit 1 bezeichnete Auslösevorrichtung für einen Airbag in einem Kraftfahrzeug hat ein einen CMOS-Chip 2 aufweisendes elektronsicher Bauteil 3, das derart an der Karosserie 4 des Kraftfahrzeugs befestigt ist, dass bei einer Deformation der Karosserie 4 Kräfte von der Karosserie 4 auf den CMOS-Chip 2 übertragen werden.

In den CMOS-Chip 2 sind mittels eines Standard-CMOS-Prozesses mehrere mit ihrer Hauptmessrichtung quer zueinander angeordnete Kraftsensoren 5 Integriert, die jeweils einen Messsignalausgang 6 aufweisen, der mit einer Auswerteeinrichtung 7 verbunden ist, die ebenfalls in den CMOS-Chip 2 integriert ist. An den Messsignalausgängen 6 liegen Messsignale für unterschiedliche Komponenten einer auf den CMOS-Chip 2 einwirkenden Kraft an. Die Komponenten können beispielsweise die x-, y- und z-Komponente der Kraft in einem kartesischen Koordinatensystem sein.

Die Kraftsensoren 5 haben jeweils eine Wheatstone Brücke, deren Brückenwiderstände durch Piezoelemente gebildet sind. Bei einer Krafteinwirkung auf den CMOS-Chip 2 liegt an den einzeinen Messsignalausgängen 6 jeweils eine von der Kraft abhängige elektrische Spannung an.

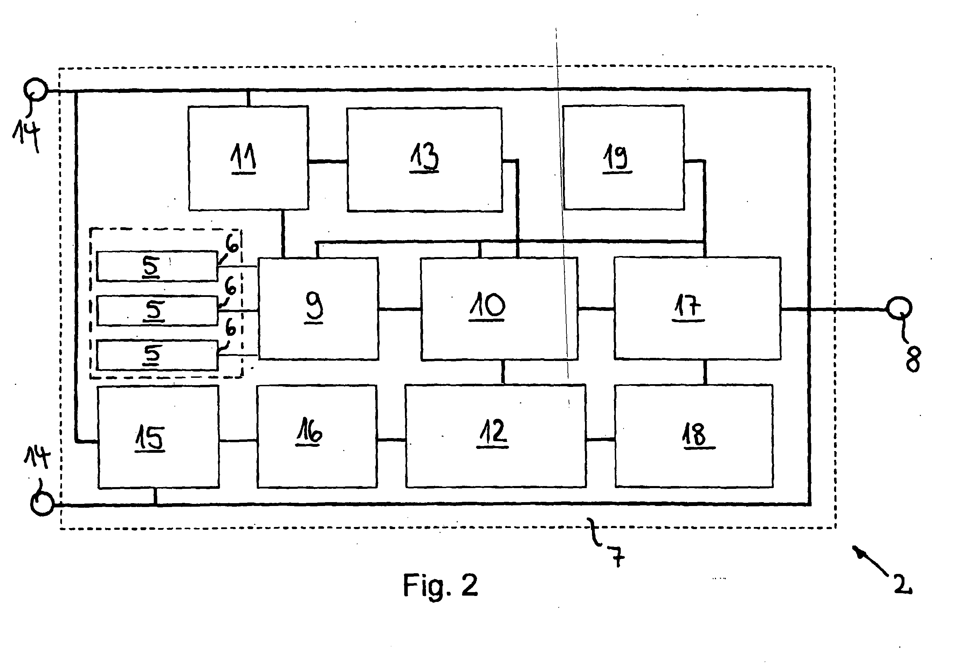

Die Auswerteeinrichtung 7 hat einen Ausgangsanschluss 8, an dem in Abhängigkeit von den Messsignalen der Kraftsensoren 5 ein Auslösesignal für den Airbag anlegbar ist. In Fig. 2 ist erkennbar, dass die Messsignalausgänge 6 jeweils über einen Analog-/Digital-Konverter 9 mit einem Eingang eines Signalprozessors 10 verbunden sind. Der Analog-/Digital-Konverter 9 ist an einer Referenzspannungsquelle 11 angeschlossen, die in den CMOS-Chip 2 integriert ist.

An dem Signalprozessor 10 Ist ein nicht flüchtiger Datenspeicher 12, wie z.B. ein EEPROM angeschlossen, in dem mindestens ein Auslösekennwert gespeichert ist.

Der Auslösekennwert kann z.B. einen Grenzwert für die Anstiegsgeschwindigkeit der Messsignale umfassen. Mit Hilfe des Signalprozessors 10 werden die Messsignale und/oder daraus abgeleitete Messwerte mit dem mindestens ein Auslösekennwert verglichen. In Abhängigkeit von dem Ergebnis dieses Vergleichs wird das Auslösesignal erzeugt und an den Ausgangsanschluss 8 angelegt.

In den CMOS-Chip 2 ist außerdem ein Temperatursensor 13 integriert, der zur Kompensation von bei Temperaturschwankungen auftretenden Veränderungen der Messsignale mit dem Signalprozessor 10 verbunden ist.

Der CMOS-Chip 2 hat Spannungsversorgungsanschlüsse 14, die mit einer in der Zeichnung nicht näher dargestellten Bordspannungsquelle des Kraftfahrzeugs verbunden sind, beispielsweise mit einer Autobatterie. In den CMOS-Chip 2 ist eine Überwachungseinrichtung 15 für die Versorgungsspannung integriert, die mit den Spannungsversorgungsanschlüssen 14 und einer Verriegelungseinrichtung 16 verbunden ist. Mit Hilfe der Verriegelungseinrichtung wird das Auslesen des Datenspeichers 12 gesperrt, wenn an den Spannungsversorgungsanschlüsse 14 eine zu geringe elektrische Betriebsspannung anliegt.

In den CMOS-Chip ist ein BUS-Interface 17 integriert ist, das zum PSI5-Standard kompatibel ist. Das BUS-Interface 17 ist zur Ausgabe des Auslösesignals an den Ausgangsanschluss 8 mit dem Signalprozessor 10 und dem Ausgangsanschluss 8 verbunden. An dem BUS-Interface 17 ist außerdem eine Diagnoseeinrichtung 18 angeschlossen, die in den CMOS-Chip 2 integriert ist. Mit Hilfe der Diagnoseeinrichtung 18 können der Betriebszustand der Bauteils 3 und insbesondere das Auftreten von Fehlern überwacht werden. Bei Bedarf und/oder auf Anforderung kann ein entsprechendes Statussignal auf den BUS gesendet werden.

Erwähnt werden soll noch, dass zum Erzeugen eines Taktsignals ist ein Oszillator 19 in den CMOS-Chip 2 integriert ist. Der Oszillator 19 ist mit Taktsignaleingängen des Analog-/Digital-Konverters 9, des Signalprozessors 10 und des BUS-Interfaces 17 verbunden.

Bei dem In Fig. 1 gezeigten Ausführungsbeispiel ist der CMOS-Chip über eine etwa parallel zu seiner Haupterstreckungsebene verlaufende Klebstoffschicht 20 flächig und kraftschlüssig mit einem ersten Oberflächenbereich 21 a der Fahrzeug-Karosserie 4 verbunden. Die aus dem CMOS-Chip 2 und der Klebstoffschicht 20 bestehende Anordnung ist mit einer verfestigten Vergussmasse 22 umspritzt, die an einem die Klebstoffschicht 20 seitlich umgrenzenden zweiten Oberflächenbereich 21 b der Fahrzeug-Karosserie 4 anhaftet und gegen diesen abdichtet.

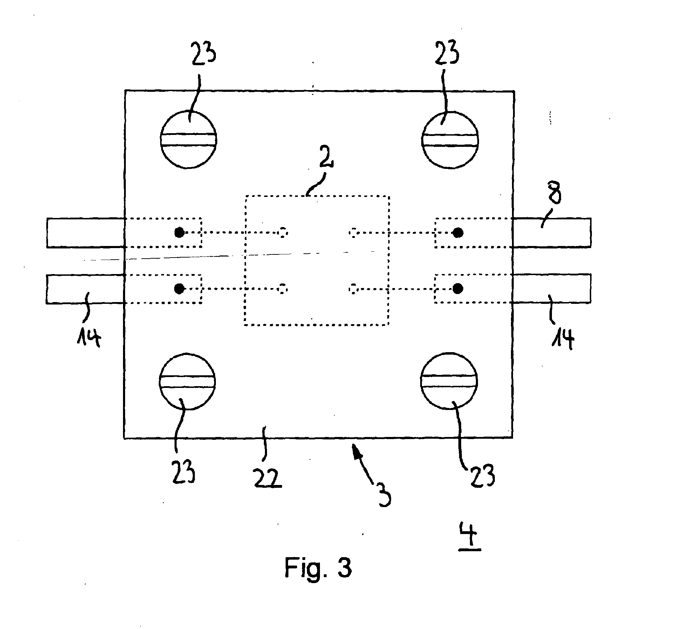

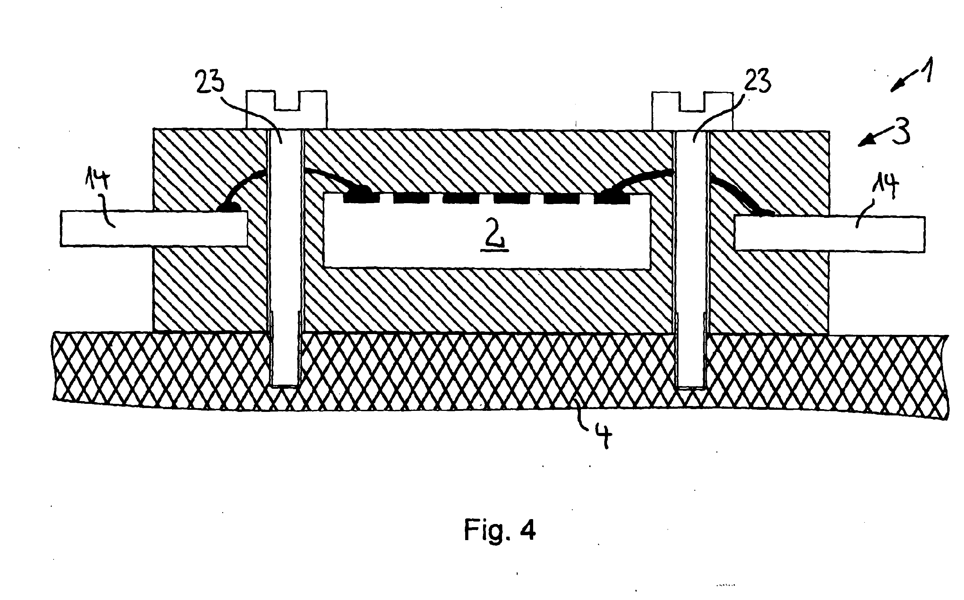

Bei dem Ausführungsbeispiel gemäß Fig. 3 und 4 ist der CMOS-Chip 2 mit einer Vergussmasse 22 umspritzt, die eine Gehäuse bildet. Die Vergussmasse 22 weist mehrere seitlich voneinander beabstandete Lochungen auf, durch die jeweils ein Befestigungselement 23, nämlich eine Schraube hindurchgeführt ist. Das Befestigungselement 23 hat an seinem einen Ende einen mit der Karosserie 4 verschraubten Gewindeabschnitt und übergreift mit seinem anderen Ende den die Lochung umgrenzenden Rand der Vergussmasse 22. Dadurch wird das Bauteil 3 an die Karosserie 4 angepresst. In Fig. 3 ist erkennbar, dass der CMOS-Chip 2 zwischen den Befestigungselementen 23 angeordnet ist.

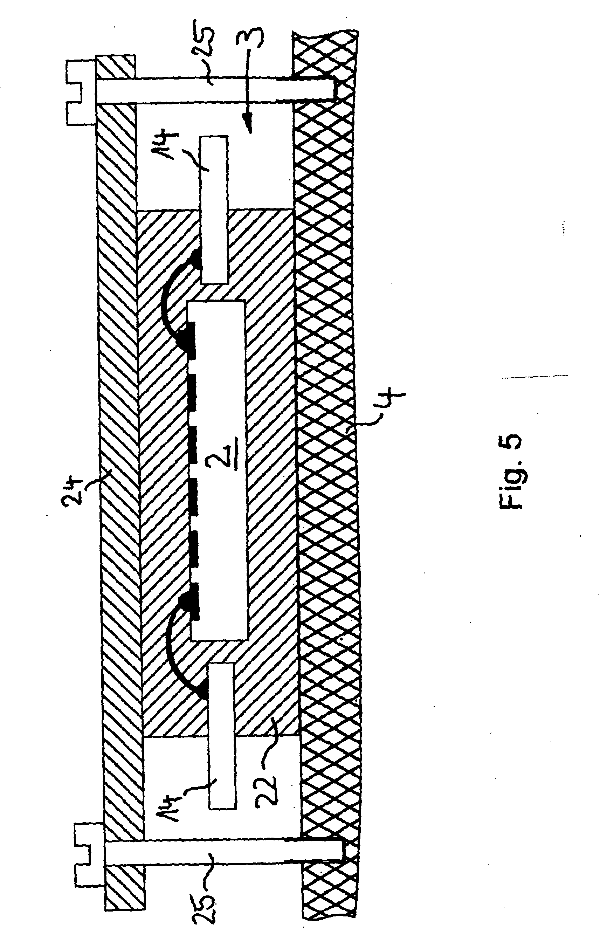

Bei dem in Fig. 5 gezeigten Ausführungsbeispiel ist das Bauteil 3 von einem plattenförmigen Halteteil 24 überdeckt, das beidseits des elektronischen Bauteils 3 mit Hilfe von Schrauben 25 mit der Karosserie 2 verspannt ist. Zwischen den Schrauben 25 ist das Halteteil 24 über das elektronische Bauteil 3 gegen die Karosserie 2 abgestützt ist. Dabei kommt das Bauteil 3 flächig an der Karosserie 2 zur Anlage.

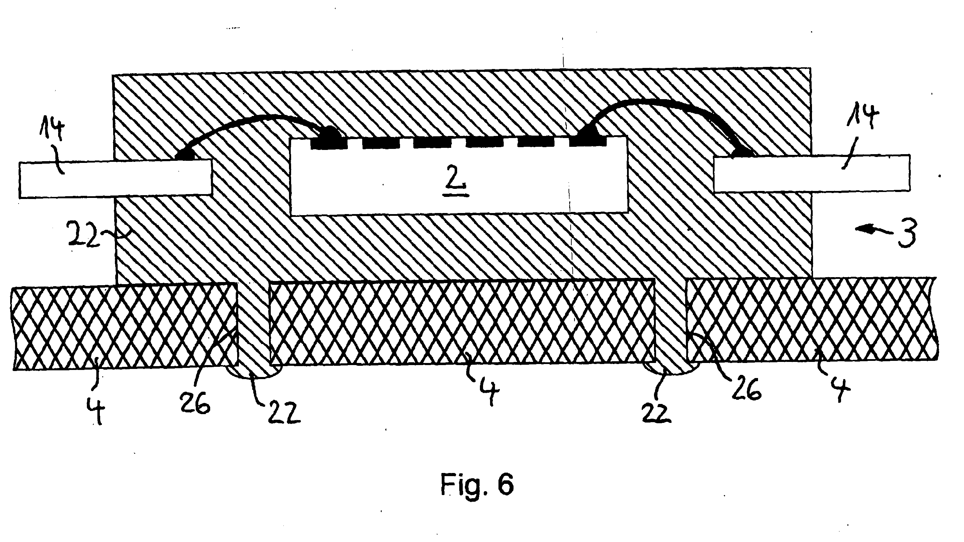

Wie in Fig. 6 erkennbar ist, kann der CMOS-Chip 2 auch mit einer Vergussmasse 22 umkapselt sein, die kraftschlüssig an der Karosserie 4 anhaftet und Lochungen 26 der Karosserie 4 durchsetzt. Dabei hintergreift die Vergussmasse 22 an der dem CMOS-Chip 2 abgewandten Seite der Karosserie 4 den Randbereich der Lochungen 26 formschlüssig.

## Patentansprüche

1. Auslösevorrichtung (1) für eine Sicherheitseinrichtung in einem Kraftfahrzeug, insbesondere für einen Airbag, mit einem mindestens einen Kraftsensor (5) aufweisenden elektrischen Bauteil (3), das derart an der Karosserie (4) des Kraftfahrzeugs befestigt ist, dass an einen Messsignalausgang (6) des Kraftsensors (5) ein von der Deformation der Karosserie (4) abhängiges Messsignal anlegbar ist, und mit einer mit dem Messsignalausgang (6) verbundenen Auswerteeinrichtung (7) zu Verarbeitung des Messsignals, wobei der Kraftsensor (5) mindestens ein Piezoelement aufweist, das zusammen mit der Auswerteeinrichtung monolithisch in einen CMOS-Chip (2) integriert ist, **dadurch gekennzeichnet, dass** in dem CMOS-Chip (2) mindestens ein Temperatursensor (13), ein Sensor zur Messung einer elektrischen Kapazität und/oder ein Feuchtigkeitssensor integriert ist, der mit der Auswerteeinrichtung verbunden ist.

2. Auslösevorrichtung (1) nach Anspruch 1, **dadurch gekennzeichnet, dass** der CMOS-Chip (2) mehrere Piezoelemente aufweist, die vorzugsweise zu einer Brückenschaltung, insbesondere einer Wheatstone Brücke miteinander verbunden sind.

3. Auslösevorrichtung (1) nach Anspruch 1 oder 2, **dadurch gekennzeichnet, dass** die Auswerteeinrichtung (7) einen nicht flüchtigen Datenspeicher (12) hat, in dem mindestens ein Auslösekennwert gespeichert ist, dass die Auswerteeinrichtung (7) eine Vergleichseinrichtung zum Vergleichen des mindestens einen Auslösekennwerts mit dem Messsignal aufweist, und dass die Auswerteeinrichtung (7) derart ausgestaltet ist, dass ein Auslösesignal in Abhängigkeit von dem Ergebnis dieses Vergleichs generierbar ist.

4. Auslösevorrichtung (1) nach einem der Ansprüche 1 bis 3, **dadurch gekennzeichnet, dass** der CMOS-Chip (2) mehrere mit der Auswerteeinrichtung (7) verbundene Piezoelemente aufweist, mit denen Kraft-Messsignale für mindestens zwei quer zueinander angeordnete Hauptmessrichtungen messbar sind, und dass die Auswerteeinrichtung (7) derart ausgestaltet ist, dass das Auslösesignal in Abhängigkeit vom Betrag, der Änderungsgeschwindigkeit und/oder der Richtung eines aus den Messsignalen gebildeten resultierenden Messsignals generierbar ist.

5. Auslösevorrichtung (1) nach einem der Ansprüche 1 bis 4, **dadurch gekennzeichnet, dass** mindestens zwei Piezoelemente aufweist, die unter einem Winkel von etwa 45° zueinander angeordnet sind, und dass zumindest eines dieser Piezoelemente mit seiner Hauptmessrichtung vorzugsweise parallel zur Ausrichtung der Kristalle im CMOS-Chip (2) und/oder zu einem Randbereich und/oder einer Kante des CMOS-Chips (2) angeordnet ist.

6. Auslösevorrichtung (1) nach einem der Ansprüche 1 bis 5, **dadurch gekennzeichnet, dass** der CMOS-Chip (2) über mindestens eine vorzugsweise etwa parallel zu seiner Haupterstreckungsebene verlaufende Klebstoffschicht (20) flächig und kraftschlüssig mit einem ersten Oberflächenbereich (21 a) der Fahrzeug-Karosserie (4) verbunden ist, und dass die aus dem CMOS-Chip (2) und der mindestens einen Klebstoffschicht (20) bestehende Anordnung mit einer verfestigten Vergussmasse (22) überdeckt ist, die dicht mit einem die Klebstoffschicht (20) seitlich umgrenzenden zweiten Oberflächenbereich (21 b) der Fahrzeug-Karosserie (4) verbunden ist.

7. Auslösevorrichtung (1) nach einem der Ansprüche 1 bis 6, **dadurch gekennzeichnet, dass** der CMOS-Chip (2) über mindestens zwei gestapelte Klebstoffschichten (20) mit dem ersten Oberflächenbereich (21 a) der Fahrzeug-Karosserie (4) verbunden ist, und dass zwischen diesen Klebstoffschichten eine Metallfolie angeordnet ist.

8. Auslösevorrichtung (1) nach einem der Ansprüche 1 bis 7, **dadurch gekennzeichnet, dass** der CMOS-Chip (2) mit einer diesen dicht umschließenden Vergussmasse (22) umspritzt ist, und dass die Vergussmasse (22) mindestens zwei seitlich voneinander beabstandete Lochungen aufweist, durch die Befestigungselemente (23) hindurchgeführt sind, über welche das durch den CMOS-Chip (2) und die Vergussmasse (22) gebildete elektronische Bauteil (3) kraftschlüssig mit der Karosserie (4) verbunden ist.

9. Auslösevorrichtung (1) nach einem der Ansprüche 1 bis 8, **dadurch gekennzeichnet, dass** der CMOS-Chip (2) über eine an der Karosserie (4) anhaftende Vergussmasse kraftschlüssig mit der Karosserie (4) des Kraftfahrzeugs verbunden ist, und dass die Vergussmasse vorzugsweise zwischen dem CMOS-Chip (2) und der Karosserie (4) angeordnet ist und/oder die Karosserie (4) hintergreift.

10. Auslösevorrichtung (1) nach einem der Ansprüche 1 bis 9, **dadurch gekennzeichnet, dass** das Bauteil (3) von einem vorzugsweise plattenförmigen Halteteil (24) überdeckt ist, und dass das Halteteil (24) beidseits des elektronischen Bauteils (3) an Befesfigungsstellen mit der Karosserie (4) verspannt und zwischen den Befestigungsstellen über das elektronische Bauteil (3) gegen die Karosserie (4) abgestützt ist.

11. Auslösevorrichtung (1) nach einem der Ansprüche 1 bis 10, **dadurch gekennzeichnet, dass** das Bauteil (3) an einem einen Teil der Außenhaut der Karosserie (4) bildenden Karosseriewandung befestigt ist, insbesondere an deren der Fahrzeugaußenseite abgewandten Rückseite.

12. Auslösevorrichtung (1) nach einem der Ansprüche 1 bis 11, **dadurch gekennzeichnet, dass** in den CMOS-Chip (2) ein BUS-Interface (17) integriert ist, das vorzugsweise zum PSI5-Standard kompatibel ist.

13. Auslösevorrichtung (1) nach einem der Ansprüche 1 bis 12, **dadurch gekennzeichnet, dass** sie eine Diagnoseeinrichtung aufweist, die Mittel zum Detektieren eines im Messsignal enthaltenen Signalanteils aufweist, der durch Vibrationen hervorgerufen wird, die durch einen Antriebsmotor des Kraftfahrzeugs verursacht werden, insbesondere durch einen Verbrennungsmotor.

14. Auslösevorrichtung (1) nach einem der Ansprüche 1 bis 13, **dadurch gekennzeichnet, dass** in dem CMOS-Chip (2) mindestens ein Magnetfeldsensor integriert ist.

## Claims

1. Trigger device (1) for safety equipment in a motor vehicle, particularly for an airbag, with an electrical component (3) which comprises at least one force sensor (5) and which is so fastened to the bodywork (4) of the motor vehicle that a measurement signal dependent on deformation of the bodywork (4) can be provided at a measurement signal output (6) of the force sensor (5), and with an evaluating device (7), which is connected with the measurement signal output (6), for processing the measurement signal, wherein the force sensor (5) comprises at least one piezo element which together with the evaluating device is monolithically integrated in a CMOS chip (2), **characterised in that** at least one temperature sensor (13), sensor for measuring an electrical capacitance and/or moisture sensor, which is connected with the evaluating device, is or are integrated in the CMOS chip (2).

2. Trigger device (1) according to claim 1, **characterised in that** the CMOS chip (2) comprises a plurality of piezo elements which are preferably connected together to form a bridge circuit, particularly a Wheatstone bridge.

3. Trigger device (1) according to claim 1 or 2, **characterised in that** the evaluating device (7) comprises a non-volatile data memory (12) in which at least one trigger characteristic value is stored, that the evaluating device (7) comprises a comparison device for comparing the at least one trigger characterisic value with the measurement signal and that the evaluating device (7) is so designed that a trigger signal can be generated in dependence on the result of this comparison.

4. Trigger device (1) according to any one of claims 1 to 3, **characterised in that** the CMOS chip (2) comprises a plurality of piezo elements connected with the evaluating device (7), by which force measurement signals for at least two main measuring directions arranged transversely relative to one another are measurable, and that the evaluating device (7) is so designed that the trigger signal can be generated in dependence on the amount, the change in speed and/or the direction of a resultant measurement signal formed from the measurement signals.

5. Trigger device (1) according to any one of claims 1 to 4, **characterised in that** it comprises at least two piezo elements which are arranged at an angle of approximately 45° to one another and that at least one of these piezo elements is arranged with its main measuring direction preferably parallel to the orientation of the crystals in the CMOS chip (2) and/or to an edge region and/or an edge of the CMOS chip (2).

6. Trigger device (1) according to any one of claims 1 to 5, **characterised in that** the CMOS chip (2) is connected over an area and by force-locking couple with a first surface area (21a) of the vehicle bodywork (4) by way of at least one adhesive layer (20) preferably extending approximately parallel to the main dimensional plane of the chip and that the arrangement consisting of the CMOS chip (2) and the at least one adhesive layer (20) is covered by a solidified encapsulating material (22) which is sealingly connected with a second surface area (21b) of the vehicle bodywork (4) laterally bounding the adhesive layer (20).

7. Trigger device (1) according to any one of claims 1 to 6, **characterised in that** the CMOS chip (2) is connected with the first surface area (21 a) of the vehicle bodywork (4) by way of at least two stacked adhesive layers (20) and that a metal foil is arranged between these adhesive layers.

8. Trigger device (1) according to any one of claims 1 to 7, **characterised in that** the CMOS chip (2) is injection-moulded around by a encapsulating material (22) sealingly enclosing this and that the encapsulating material (22) has at least two laterally spaced-apart holes through which are guided fastening elements (23) by way of which the electronic component (3) formed by the CMOS chip (2) and the encapsulating material (22) is connected with the bodywork (4) by force-locking couple.

9. Trigger device (1) according to any one of claims 1 to 8, **characterised in that** the CMOS chip (2) is connected with the bodywork (4) of the motor vehicle by force-locking couple by way of a encapsulating material adhering to the bodywork (4) and that the encapsulating material is preferably arranged between the CMOS chip (2) and the bodywork (4) and/or engages behind the bodywork (4).

10. Trigger device (1) according to any one of claims 1 to 9, **characterised in that** the component (3) is covered by a preferably plate-shaped retaining part (24) and that the retaining part (24) on either side of the electronic component (3) is tightened to the bodywork (4) at fastening points and between the fastening points is supported relative to the bodywork (4) by way of the electronic component (3).

11. Trigger device (1) according to any one of claims 1 to 10, **characterised in that** the component (3) is fastened to a bodywork wall forming a part of the outer skin of the bodywork (4), particularly to the rear side of the wall remote from the bodywork outer side.

12. Trigger device (1) according to any one of claims 1 to 11, **characterised in that** a bus interface (17) is integrated in the CMOS chip (2) and is preferably compatible with the PS15 Standard.

13. Trigger device (1) according to any one of claims 1 to 12, **characterised in that** it comprises a diagnostic device comprising means for detecting a signal component which is present in the measurement signal and which is produced by vibrations caused by a drive motor of the motor vehicle, particularly by a combustion engine.

14. Trigger device (1) according to any one of claims 1 to 13, **characterised in that** at least one magnetic field sensor is integrated in the CMOS chip (2).

## Revendications

1. Dispositif de déclenchement (1) pour un dispositif de sécurité dans un véhicule automobile en particulier pour un airbag, comprenant au moins un composant électrique (3) présentant un capteur de force (5) fixé de telle façon à la carrosserie du véhicule automobile, que l'on puisse appliquer à une sortie de signal de mesure (6) du capteur de force (5) un signal de mesure dépendant de la déformation de la carrosserie, et comprenant un dispositif d'exploitation (7) relié à la sortie du signal de mesure (6) pour le traitement du signal de mesure dans lequel le capteur de force (5) présente au moins un piézoélément qui est intégré de façon monolithique dans une puce électronique CMOS (2) avec le dispositif d'exploitation **caractérisé en ce que** dans la puce CMOS (2) est intégré au moins un capteur de température (13), un capteur pour la mesure d'une capacité électrique et/ou un capteur d'humidité qui sont reliés au dispositif d'exploitation.

2. Dispositif de déclenchement (1) selon la revendication 1 **caractérisé en ce que** la puce CMOS (2) présente plusieurs éléments piezo-électriques qui sont reliés entre eux, de préférence selon un circuit en pont, en particulier selon un pont de Wheatstone.

3. Dispositif de déclenchement (1) selon la revendication 1 ou 2 **caractérisé en ce que** le dispositif d'exploitation (7) comporte une mémoire de données non volatile (12), dans laquelle est stockée au moins une valeur de déclenchement, **en ce que** le dispositif d'exploitation (7) présente un dispositif comparateur pour comparer la, au moins une, valeur de déclenchement avec le signal de mesure et **en ce que** le dispositif d'exploitation est configuré de façon qu'un signal de déclenchement puisse être généré en fonction du résultat de la comparaison.

4. Dispositif de déclenchement (1) selon l'une des revendications 1 à 3 **caractérisé en ce que** la puce CMOS (2) présente plusieurs piézoéléments reliés au dispositif d'exploitation (7) au moyen desquels des signaux de mesure de force dans au moins deux directions principales de mesure perpendiculaires l'une à l'autre sont mesurables et **en ce que** le dispositif d'exploitation (7) est configuré pour que le signal de déclenchement puisse être généré en fonction de la valeur de la vitesse de modification et/ou de la direction d'un signal de mesure résultant, formé à partir des signaux de mesure.

5. Dispositif de déclenchement (1) selon l'une des revendications 1 à 4 **caractérisé en ce qu'**il présente au moins deux piezoéléments disposés selon un angle d'environ 45° l'un par rapport à l'autre et **en ce que** la direction principale de mesure d'au moins un de ces piézoéléments est de préférence parallèle à la direction d'extension des cristaux dans la puce CMOS (2) et/ou à une zone de bordure et/ou une arête de la puce CMOS (2).

6. Dispositif de déclenchement (1) selon l'une des revendications 1 à 5 **caractérisé en ce que**, par l'intermédiaire d'au moins une couche d'adhésif (20), s'étendant de préférence à peu près parallèlement à son plan d'étendue principale, la puce électronique CMOS (2) est reliée, en surface et par une liaison à ajustement serré, à une première zone de surface (21 a) de la carrosserie du véhicule automobile (4), et **en ce que** l'agencement, composé de la puce électronique CMOS (2) et de la au moins une couche d'adhésif (20), est recouvert d'une masse de scellement (22) solidifiée, reliée de manière étanche à une deuxième zone de surface (21b), entourant latéralement la couche d'adhésif (20) de la carrosserie du véhicule automobile (4).

7. Dispositif de déclenchement (1) selon l'une des revendications 1 à 6, **caractérisé en ce que**, par l'intermédiaire d'au moins deux couches d'adhésif (20) empilées, la puce électronique CMOS (2) est reliée à la première zone de surface (21a) de la carrosserie du véhicule automobile (4), et **en ce qu'**une feuille métallique est disposée entre ces couches d'adhésif.

8. Dispositif de déclenchement (1) selon l'une des revendications 1 à 7, **caractérisé en ce que** la puce électronique CMOS (2) est enrobée par injection d'une masse de scellement (22) entourant celle-ci de manière étanche, et **en ce que** la masse de scellement (22) présente au moins deux trous espacés latéralement l'un de l'autre, à travers lesquels sont passés des éléments de fixation (23), par l'intermédiaire desquels le composant (3) électronique, formé de la puce électronique CMOS (2) et de la masse de scellement (22), est replié, par une liaison à ajustement serré, à la carrosserie (4).

9. Dispositif de déclenchement (1) selon l'une des revendications 1 à 8, **caractérisé en ce que** la puce électronique CMOS (2) est reliée, par une liaison à ajustement serré, à la carrosserie (4) du véhicule automobile, par l'intermédiaire d'une masse de scellement adhérant à la carrosserie (4), et **en ce que** la masse de scellement est disposée de préférence entre la puce électronique CMOS (2) et la carrosserie (4) et/ou prend la carrosserie (4) par l'arrière.

10. Dispositif de déclenchement (1) selon l'une des revendications 1 à 9, **caractérisé en ce que** le composant (3) est recouvert par une pièce de maintien (24), se présentant de préférence sous la forme d'une plaque, et **en ce que** la pièce de maintien (24) est bridée des deux côtés du composant (3) électronique, à des emplacements de fixation, à la carrosserie (4), et soutenu contre la carrosserie (4), entre les emplacements de fixation, par l'intermédiaire du composant (3) électronique.

11. Dispositif de déclenchement (1) selon l'une des revendications 1 à 10, **caractérisé en ce que** le composant (3) est fixé à une paroi de la carrosserie, formant une partie de la peau extérieure de la carrosserie (4), en particulier à sa face arrière, opposée au côté extérieur de véhicule.

12. Dispositif de déclenchement (1) selon l'une des revendications 1 à 11, **caractérisé en ce qu'**une interface de BUS (17), de préférence compatible avec le standard PSI5, est intégrée dans la puce électronique CMOS (2).

13. Dispositif de déclenchement (1) selon l'une des revendications 1 à 12, **caractérisé en ce qu'**elle présente un dispositif de diagnostic, comprenant des moyens pour détecter une partie de signal, contenue dans le signal de mesure, provoquée par des vibrations, causées par un moteur d'entraînement du véhicule automobile, en particulier par un moteur à combustion.

14. Dispositif de déclenchement (1) selon l'une des revendications 1 à 13, **caractérisé en ce que**, dans la puce électronique CMOS (2), est intégré au moins un capteur de champ magnétique.
